Europäisches Patentamt

European Patent Office

Office européen des brevets

(19)

(11) Veröffentlichungsnummer: **0 154 782**
**B1**

(12) **EUROPÄISCHE PATENTSCHRIFT**

(45) Veröffentlichungstag der Patentschrift:
02.09.87

(21) Anmeldenummer: **85100802.9**

(22) Anmeldetag: **26.01.85**

(51) Int. Cl.⁴: **H 05 K 7/14**

(54) Gehäuse für Befehls- und Meldegeräte.

(30) Priorität: **13.02.84  CH 675/84**

(43) Veröffentlichungstag der Anmeldung:
**18.09.85 Patentblatt 85/38**

(45) Bekanntmachung des Hinweises auf die Patenterteilung:
**02.09.87 Patentblatt 87/36**

(84) Benannte Vertragsstaaten:
**AT BE DE FR GB IT LU NL SE**

(56) Entgegenhaltungen:
**DE-B-1 665 560**
**DE-B-2 619 340**
**DE-U-7 044 937**
**FR-A-2 041 482**
**US-A-3 937 352**

(73) Patentinhaber: **Elektro- Apparatebau Olten AG,
Tannwaldstrasse 88, CH- 4600 Olten (CH)**

(72) Erfinder: **Berger, Fritz, Hofacker 381, CH- 4625
Oberbuchsiten (CH)**

(74) Vertreter: **Fillinger, Peter, Dr., Rütistrasse 1a, CH-
5400 Baden (CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1987

EP 0 154 782 B1

## Beschreibung

Die vorliegende Erfindung bezieht sich auf ein Gehäuse für Befehls- und Meldegeräte mit rechteckigen Querschnitt, einem frontseitigen Rahmen und zwei gegenüberliegend und parallel zur Gehäuselängsachse angeordneten Schrauben, die dreh - und unverlierbar in Gehäuse gelagert sind und deren Gewindeschaft je eine nach aussen offene Gehäusenische durchsetzen und in der Gehäusenische einen Klemmkörper tragen, der beim Drehen der Schrauben zwischen zwei Endlagen verschwenkbar ist und in der ersten Endlage mit Teilen die Nische überragt und in der zweiten Endlage innerhalb der Nische liegt.

Derartige Gehäuse sind bekannt, da auf dem Markt erhältlich. Bei diesen sind auf zumindest zwei einander gegenüberliegenden Gehäuseseiten je eine Nische zur Aufnahme der Klemmutter angeordnet, um eine sichere und symmetrische Befestigung des Gehäuses in der Frontplatte einer Schalttafel zu erreichen.

Die vorliegende Erfindung stellt sich die Aufgabe, ein Gehäuse der erwähnten Art, derart zu verbessern, dass unter Verwendung von nur zwei Schrauben möglichst grosse Klemmflächen für die Klemmverbindung mit der Frontplatte einer Montagewand möglich sind.

Erfindungsgemäss wird diese Aufgabe dadurch gelöst, dass sich die Schrauben diagonal gegenüber liegen, dass die Nische sich in beide der in einer Ecke schneidenden Gehäuseflächen öffnet, und dass der Klemmkörper in der zweiten Endlage mit einem Teil die eine Gehäusefläche und mit einem anderen Teil die andere Gehäusefläche überragt, wobei die überragenden Teile je eine Klemmfläche aufweisen, welche Klemmflächen in einer zur zugewandten Seite des Rahmens parallelen Ebene liegen.

Anhand der beiliegenden schematischen Zeichnung wird die Erfindung beispielsweise erläutert. Es zeigen:

Fig. 1 eine Ansicht einer Ecke eines in die Frontwand einer Schalttafel montierten Gehäuses und

Fig. 2 eine Draufsicht auf Fig. 1.

In die Frontplatte 1 einer Schalttafel ist das Gehäuse 2 eines Befehls- oder Meldegerätes montiert. Das im Querschnitt viereckige Gehäuse 2 weist am oberen Ende einen Rahmen 3 auf, der gegen die Sichtseite der Frontplatte 1 anliegt. Unterhalb des Rahmens 3 ist in zwei einander diagonal gegenüberliegenden Ecken des Gehäuses je eine gegen das Gehäuseinnere rückspringende Nische 4 angeordnet, die sich in die beiden in der Ecke schneidenden Gehäuseebenen 5 und 6 öffnet. Die Nische 4 wird vom Schaft einer Schraube 7 durchsetzt, deren Kopf 8 im Gehäuse inneren liegt und von der Frontseite her mittels eines Schraubenziehres zugänglich ist. Der Kopf 8 der Schraube 7 liegt gegeneinen durch die Nische 4 gebildeten Absatz 9 der Gehäusewand an, die mit einer Bohrung versehen ist, welche den Schraubenschaft flüssigkeitsdicht umgibt. Der Absatz 9 kann zum Abdichten der Schraubendurchführung auch einen den Schraubenschaft umgebenden Ringwulst aufweisen, gegen welchen die Schraubenkopfunterseite festgespannt liegt. Das untere Schraubenschaftende ist in einer Bohrung 10 der Gehäusewand gelagert und weist eine Ringnut 11 auf, in die eine die Bohrung 10 nach innen überragende Ringrippe 12 greift. Bohrung 10 und Ringrippe 11 bilden eine Rastverbindung, welche die Schraube 7 drehbar aber unverlierbar im Gehäuse hält. Auf den mit einem Gewinde 13 versehenen Teil des Schraubenschaftes ist ein Klemmkörper 14 mit einem Muttergewinde aufgeschraubt. Dieser weist eine nach oben gegen den Rahmen 3 überstehende Rippe 15 auf, zwischen der einerseits und dem Rahmen 3 anderseits die Frontplatte 1 einklemmbar ist.

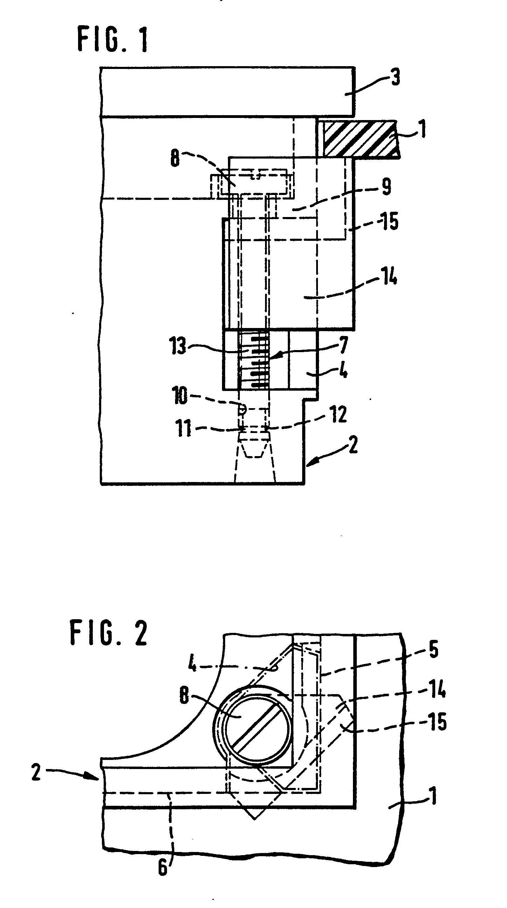

Durch ein Drehen der Schraube 7 mit einem Schraubenzieher kann der Klemmkörper 14 zwischen zwei Schwenklagen, die in Fig. 2 mit gestrichelten und strichpunktierten Linien festgehalten sind. In einer Schwenklage überragt der Klemmkörper 14 mit Teilen die Gehäuseaussenseite, d.h., die durch die Gehäusewand gebildeten Ebenen 5 und 6, wodurch eine relativ grosse gegen die Frontplatte 1 anliegende Klemmfläche entsteht. In der anderen Schwenklage (in Fig. 2 gestrichelt gezeichnet) liegt der Klemmkörper 14 innerhalb der Nische 4.

Die Montage des Gehäuses an der Frontplatte 1 erfolgt, derart, dass es durch eine entsprechende Durchbrechung in der Frontplatte 1 hindurchgeschoben wird, wenn sich der Klemmkörper 14 vollständig innerhalb der Nische 4 befindet. Dies kann durch ein entsprechendes Drehen an der Schraube 7 erreicht werden. Ist das Gehäuse 2 in die Frontplatte 1 hineingeschoben, wird die Schraube 7 mit dem Schraubenzieher derart gedreht, dass der Klemmkörper 14 in die andere Schwenklage verschwenkt wird in der er mit Teilen das Gehäuse überragt und von der Nischenwand am weiteren mit Drehen gehindert wird. Beim weiteren Drehen der Schraube gleitet der Klemmkörper 14 am Schraubenschaft nach oben, bis er gegen die Rückseite der Frontplatte 1 anliegt und diese zwischen sich und dem Rahmen 3 verspannt.

Ist das Gehäuse 2 aus der Frontplatte zu entfernen, wird der Schraubenzieher wieder angesetzt und die Schraube 7 mit entgegengesetztem Drehsinn gedreht. Sobald die Haftreibung zwischen dem Klemmkörper 14 und der Frontplattenrückseite klein genugt wird, wird der Klemmkörper 14 zurück und wieder in die Nische 4 hineingeschwenkt, wo er wieder gegen die Nischenwand auftrifft, die ihn am weiteren Mitdrehen hindert. Sobald beide Klemmkörper 14 am Gehäuse 2 diese Stellung einnehmen, kann das Gehäuse in einfacher Weise frontseitig aus der Frontplatte 1 herausgezogen werden.

## Patentansprüche

1. Gehäuse für Befehls- und Meldegeräte mit rechteckigem Querschnitt, einem frontseitigen Rahmen (3) und zwei gegenüber liegend und parallel zur Gehäuselängsachse angeordneten Schrauben (7), die dreh- und unverlierbar im Gehäuse (2) gelagert sind und deren Gewindeschaft je eine nach aussen offene Gehäusenische (4) durchsetzen und in der Gehäusenische (4) einen Klemmkörper (14) tragen, der beim Drehen der Schrauben (7) zwischen zwei Endlagen verschwenkbar ist und in der ersten Endlage mit Teilen die Nische (4) überragt und in der zweiten Endlage innerhalb der Nische liegt, dadurch gekennzeichnet, dass sich die Schrauben (7) diagonal gegenüber liegen, dass die Nische (4) sich in beide der in einer Ecke schneidenden Gehäuseflächen (5, 6) öffnet, und dass der Klemmkörper in der zweiten Endlage mit einem Teil die eine Gehäusefläche (5) und mit einem anderen Teil die andere Gehäusefläche (6) überragt, wobei die überragenden Teile je eine Klemmfläche aufweisen, welche Klemmflächen in einer zur zugewandten Seite des Rahmens parallelen Ebene liegen.

2. Gehäuse nach Anspruch 1, dadurch gekennzeichnet, dass die Schraube (7) zum Gehäuseinneren hin flüssigkeitsdicht gelagert ist.

## Claims

1. Housing for control and indicating apparatus, with a rectangular cross-section, a front frame (3), and two screws (7) which are situated in opposite positions and parallel to the longitudinal axis of the housing, which are mounted rotatably and non-loosably in the housing (2) and whose screwthreaded shank in each case extends through an outwardly open housing recess (4) and carries in the housing recess (4) a clamping element (14), which clamping element being pivotable between two end positions when the respective screw (7) is turned, in the first end position having portions projecting beyond the recess (4) and in the second position being situated within the recess, characterised in that the screws (7) are situated diagonally opposite one another, that the recess (4) opens into both housing surfaces (5, 6) which meet at a corner, and that the clamping element in the second end position projects with one portion beyond the one housing surface (5) and with another portion beyond the other housing surface (6), the projecting portions each having a clamping surface, these clamping surfaces being situated in a plane parallel to the facing side of the frame.

2. Housing according to claim 1, characterised in that the screw (7) is mounted to be fluid-tight in the direction towards the interior of the housing.

## Revendications

1. Boîtier pour appareils de transmission d'ordres et de signalisation de section droite rectangulaire, comportant un châssis frontal (3) et deux vis (7) disposées l'une en face de l'autre et parallèlement à l'axe longitudinal du boîtier, qui sont placées dans le boîtier (2) de façon à pouvoir tourner et à être imperdables, et dont les tiges filetées traversent chacune une niche (4) du boîtier, ouverte vers l'extérieur et portent, dans la niche (4) du boîtier, un corps de serrage (14) qui peut pivoter entre deux positions terminales lors de la rotation des vis (7) et dans la première position terminale dépasse la niche par parties, tandis qu'il se trouve à l'intérieur de la niche dans la seconde position terminale, caractérisé en ce que les vis (7) sont diagonalement opposées, en ce que la niche (4) s'ouvre dans les deux faces (5, 6) du boîtier se coupant suivant une arête, et en ce que le corps de serrage fait saillie, dans la seconde position terminale, par une partie de l'une des faces du boîtier (5) et, par une autre partie, de l'autre des faces du boîtier (6), les parties faisant saillie comportant chacune une surface de serrage, ces surfaces de serrage se trouvant dans un plan parallèle au côté tourné vers le châssis.

2. Boîtier selon la revendication 1, caractérisé en ce que la vis (7) est placée de façon à assurer l'étanchéité aux liquides vers l'intérieur du boîtier.

# FIG. 1

# FIG. 2